# FASCICULE DE BREVET EUROPEEN

(11) **EP 3 968 397 B1**
(45) Date de publication et mention de la délivrance du brevet: **26.04.2023**
(21) Numéro de dépôt: 21194619.9
(22) Date de dépôt: 02.09.2021
(51) Int. Cl.: H01L 41/113, H01L 41/22

(54) **DISPOSITIF PIÉZOÉLECTRIQUE À NANO-OBJETS ALLONGÉS PIÉZOÉLECTRIQUES**
PIEZOELEKTRISCHE VORRICHTUNG MIT LÄNGLICHEN PIEZOELEKTRISCHEN NANO-OBJEKTEN
PIEZOELECTRIC DEVICE WITH ELONGATE PIEZOELECTRIC NANO-OBJECTS

(30) Priorité: 04.09.2020 FR 2009016
(43) Date de publication de la demande: 16.03.2022
(73) Titulaire: Commissariat à l'énergie atomique et aux énergies alternatives, 75015 Paris (FR); Université Grenoble Alpes, 38400 Saint-Martin-d'Hères (FR); Centre National de la Recherche Scientifique, 75016 Paris 16 (FR); Institut Polytechnique de Grenoble, 38000 Grenoble (FR)
(72) Inventeur: LAUSECKER, Clément, 37510 Ballan Miré (FR); BAILLIN, Xavier, 38054 Grenoble cedex 9 (FR); CONSONNI, Vincent, 38330 Montbonnot-Saint-Martin (FR); SALEM, Bassem, 38360 Sassenage (FR)
(74) Mandataire: Germain Maureau

(56) Documents cités:
- US-A1- 2009 066 195
- US-A1- 2010 156 249
- HINCHET R ET AL: "Performance Optimization of Vertical Nanowire-based Piezoelectric Nanogenerators", ADVANCED FUNCTIONAL MATERIALS, vol. 24, 19 février 2014 (2014-02-19), pages 971-977, XP001588673, ISSN: 1616-301X, DOI: 10.1002/ADFM.201302157
- TAO R ET AL: "Evaluation of Vertical Integrated Nanogenerator Performances in Flexion", JOURNAL OF PHYSICS: CONFERENCE SERIES, vol. 476, 012006, 2013, XP020254718, ISSN: 1742-6596, DOI: 10.1088/1742-6596/476/1/012006

## Description

### Domaine technique de l'invention

Le domaine technique de l'invention concerne la piézoélectricité et notamment un dispositif piézoélectrique, tel que par exemple un nanogénérateur piézoélectrique, comportant des nano-objets allongés piézoélectriques comme par exemple des nanofils.

### État de la technique

Un nanogénérateur piézoélectrique, aussi connu sous le sigle PENG correspondant à « piezoelectric nanogenerator » en langue anglaise, peut générer une tension électrique à partir de vibrations mécaniques appliquées au nanogénérateur piézoélectrique. Le nanogénérateur piézoélectrique est un transducteur. Les nanogénérateurs piézoélectriques présentent un fort intérêt dans le développement de systèmes électroniques portatifs de faible puissance car ils peuvent être miniaturisés et car ils permettent de rendre ces systèmes électroniques portatifs autonomes en énergie.

Le nanogénérateur piézoélectrique peut être formé selon une architecture de type nanogénérateur intégré verticalement aussi connue sous le sigle « VING » correspondant à « vertical integrated nanogenerator » en langue anglaise. Pour former le nanogénérateur selon cette architecture de type VING, il est usuellement utilisé un réseau de nanofils piézoélectriques agencés de manière orthogonale par rapport à un substrat du nanogénérateur. Ce réseau de nanofils piézoélectriques est intercalé entre deux électrodes métalliques et est enrobé dans une matrice polymère. Les nanofils piézoélectriques permettent d'augmenter significativement le rendement du nanogénérateur en comparaison à un nanogénérateur comportant une couche d'un matériau piézoélectrique agencée entre deux électrodes. Pour former ces nanofils piézoélectriques, il peut être utilisé avantageusement un matériau piézoélectrique comme un oxyde de zinc tel que ZnO ou un nitrure de gallium tel que GaN, un tel matériau piézoélectrique combine de bonnes propriétés piézoélectriques et la capacité à former des nanofils piézoélectriques spontanément par diverses techniques de croissance. Ces techniques de croissance sont typiquement le dépôt chimique en phase vapeur (aussi connu sous le signe « CVD » pour « chemical vapor déposition » en langue anglaise) ou l'épitaxie parjet moléculaire (aussi connue sous le sigle MBE pour « Molecular Beam Epitaxy » en langue anglaise). En outre, l'oxyde de zinc peut être synthétisé par des procédés basses températures, c'est-à-dire par des procédés mis en oeuvre à des températures par exemple inférieures ou égales à 200°C, tels que le dépôt en bain chimique (aussi connu sous le sigle « CBD » pour « chemical bath déposition » en langue anglaise), la synthèse hydrothermale (aussi connue sous le sigle HS pour « hydrothermal synthesis » en langue anglaise) ou encore le dépôt électrochimique (aussi connu sous le sigle « ECD » pour « electrochemical déposition » en langue anglaise). La matrice polymère a pour fonction d'assurer l'intégrité du réseau de nanofils lors de l'utilisation du PENG en stabilisant l'alignement vertical des nanofils piézoélectriques. De plus, cette matrice doit être assez souple pour permettre la déformation du réseau de nanofils piézoélectriques sous l'effet des vibrations mécaniques afin d'assurer la génération d'une tension électrique recherchée par le PENG. Ainsi, un compromis doit être trouvé entre la bonne tenue du réseau de nanofils piézoélectriques et la liberté de déformation des nanofils piézoélectriques du réseau. Cependant, le compromis se fait généralement en privilégiant la capacité de déformation des nanofils piézoélectriques solidaires du substrat au détriment d'une bonne tenue du réseau de nanofils piézoélectriques.

Le document « Self-powered nanowire devices » de Sheng Xu et al. publié dans Nature Nanotechnology, vol 5, mai 2010, pages 366 à 373, est un document décrivant des nanofils d'oxyde de zinc agencés entre deux électrodes et formés sur une tranche de silicium (« wafer de silicium » en langue anglaise) recouverte d'or. Entre les deux électrodes, une matrice polymère en polyméthacrylate de méthyle enrobe les nanofils. Une telle matrice polymère ne permet pas de remplir simultanément les deux fonctions contradictoires suivantes :
- être suffisamment rigide pour assurer la bonne tenue mécanique des nanofils par rapport à la tranche de silicium,
- être suffisamment souple pour assurer la libre déformation des nanofils.

En fait, ici la matrice favorise plutôt la déformation des nanofils au détriment de leur maintien/tenue par rapport à la tranche de silicium.

Le brevet US 8,003,982 B2 décrit différents modes de réalisation d'un générateur électrique comprenant des nanofils d'oxyde de zinc. Selon un mode de réalisation, les nanofils d'oxyde zinc sont obtenus par croissance depuis des particules de catalyseurs placées sur un substrat, et une couche déformable, comme une couche de polymère organique, est déposée sur le substrat de sorte qu'elle entoure chacun des nanofils d'oxyde zinc à un niveau prédéterminé en vue de maintenir ces nanofils pour éviter leur arrachement par rapport au substrat. Selon un autre mode de réalisation, des nanofils d'oxyde de zinc sont obtenus par croissance depuis un film d'or appartenant à un empilement comprenant successivement un substrat, un film de titane et le film d'or. Selon cet autre mode de réalisation une couche de polymère flexible élastique et molle est formée en enrobant les nanofils avant d'en libérer des extrémités longitudinales devant venir en contact avec une couche de métal, cette couche de polymère permet de favoriser la déformation des nanofils mais au détriment de leur maintien par rapport au substrat.

Des dispositifs similaires, utilisant une seule couche de polymère entourant, sont connus par le document « Evaluation of Vertical integrated Nanogenerator Performances in Flexion » de R Tao et al, JOURNAL OF PHYSICS: CONFERENCE SERIES, vol. 476, 2013, 012006, et par le demande de brevet US 2010/156249 A1.

### Objet de l'invention

L'invention a pour but d'améliorer la robustesse d'un dispositif piézoélectrique tout en permettant à ce dispositif piézoélectrique d'avoir une efficacité satisfaisante.

À cet effet l'invention est relative à un dispositif piézoélectrique comportant :
- une première électrode,
- une deuxième électrode,
- des nano-objets allongés piézoélectriques en contact avec la première électrode, les nano-objets allongés piézoélectriques s'étendant entre la première électrode et la deuxième électrode,
- une première couche d'un premier matériau, le premier matériau étant électriquement isolant, la première couche entourant une première portion longitudinale de chacun des nano-objets allongés piézoélectriques,
- une deuxième couche d'un deuxième matériau, le deuxième matériau étant électriquement isolant, la deuxième couche entourant une deuxième portion longitudinale de chacun des nano-objets allongés piézoélectriques.

La première couche est agencée entre la première électrode et la deuxième couche. L'épaisseur de la première couche est strictement inférieure à l'épaisseur de la deuxième couche. Le premier matériau présente un module de Young strictement supérieur au module de Young du deuxième matériau.

L'utilisation des première et deuxième couches présentant des épaisseurs différentes et respectivement formées en premier matériau et en deuxième matériau à modules de Young différents permet d'assurer des maintiens différents des nano-objets allongés piézoélectriques entre les première et deuxième électrodes. Ceci permet d'obtenir une structure assurant une bonne tenue des nano-objets allongés piézoélectriques, et donc d'un réseau de nano-objets que forment ces nano-objets allongés piézoélectriques, tout en conservant une liberté de déformation satisfaisante des nano-objets allongés piézoélectriques.

Le dispositif piézoélectrique peut comporter en outre une ou plusieurs des caractéristiques suivantes :
- le module de Young du premier matériau est supérieur ou égal à 5 GPa ;
- le module de Young du premier matériau est supérieur ou égal à 25 GPa ;
- le premier matériau est choisi parmi : un silsesquioxane d'hydrogène, le dioxyde de silicium, l'alumine et un nitrure de silicium ;
- le module de Young du deuxième matériau est strictement inférieur à 5 GPa ;
- le deuxième matériau est choisi parmi : un polyméthacrylate de méthyle, un silsesquioxane d'hydrogène, une résine SU-8, un polydiméthylsiloxane, un parylène C, et une résine à base d'un polymère organique et contenant du silicium ;
- chaque nano-objet allongé piézoélectrique présente un rapport de forme égal à L/D, avec L étant la longueur dudit nano-objet allongé piézoélectrique et D étant la dimension transversale maximale dudit nano-objet allongé piézoélectrique, le rapport de forme étant supérieur ou égal à 5, et D étant inférieure ou égale à 500 nm ;
- D est inférieure ou égale à 50 nm ;
- le dispositif piézoélectrique est tel que : la longueur de chacun des nano-objets allongés piézoélectriques est strictement supérieure à la somme de l'épaisseur de la première couche et de l'épaisseur de la deuxième couche, la deuxième électrode est en contact avec les nano-objets allongés piézoélectriques, au moins l'une des première et deuxième électrodes forme un contact Schottky avec les nano-objets allongés piézoélectriques ;
- la longueur de chacun des nano-objets allongés piézoélectriques est strictement inférieure à la somme de l'épaisseur de la première couche et de l'épaisseur de la deuxième couche, et la deuxième électrode est à distance des nano-objets allongés piézoélectriques ;
- les nano-objets allongés piézoélectriques comportent chacun une première extrémité longitudinale et une deuxième extrémité longitudinale, les premières extrémités longitudinales étant en contact avec la première électrode et les deuxièmes extrémités longitudinales étant en contact avec une troisième couche d'un matériau électriquement isolant, la troisième couche reliant les deuxièmes extrémités longitudinales à la deuxième électrode ;
- le matériau électriquement isolant de la troisième couche présente une permittivité relative supérieure ou égale à 3,9 ;
- le matériau électriquement isolant de la troisième couche est choisi parmi : un oxyde d'aluminium, un nitrure de silicium et un oxyde d'hafnium ;
- les nano-objets allongés piézoélectriques sont des nanofils d'oxyde de zinc ou de nitrure de gallium ;
- les nano-objets allongés piézoélectriques sont des nanotubes d'oxyde de zinc ou de nitrure de gallium ;
- les nano-objets allongés piézoélectriques sont des nanofils comportant chacun une âme en oxyde de zinc ou en nitrure de gallium, et une couche de passivation électrique agencée sur ladite âme ;
- l'épaisseur de la première couche est inférieure ou égale à 20 % de la longueur des nano-objets allongés piézoélectriques ;
- le dispositif piézoélectrique comporte un substrat, et la première électrode est agencée sur le substrat ou est formée par le substrat ;
- le dispositif piézoélectrique forme un capteur de pression, un nanogénérateur piézoélectrique ou un dispositif haptique.

L'invention est aussi relative à un procédé de fabrication d'un dispositif piézoélectrique notamment tel que décrit. Le procédé de fabrication comporte :
- une étape de formation de nano-objets allongés piézoélectriques sur une première électrode,
- une étape de formation d'une première couche d'un premier matériau de sorte que la première couche formée entoure une première portion longitudinale de chacun des nano-objets allongés piézoélectriques, le premier matériau étant électriquement isolant,
- une étape de formation d'une deuxième couche d'un deuxième matériau de sorte que la deuxième couche formée entoure une deuxième portion longitudinale de chacun des nano-objets allongés piézoélectriques, le deuxième matériau étant électriquement isolant,
- une étape de formation d'une deuxième électrode, la deuxième électrode formée étant agencée de sorte que les nano-objets allongés piézoélectriques s'étendent entre la première électrode et la deuxième électrode.

La première couche est agencée entre la première électrode et la deuxième couche, l'épaisseur de la première couche formée est strictement inférieure à l'épaisseur de la deuxième couche formée, et le premier matériau présente un module de Young strictement supérieur au module de Young du deuxième matériau.

D'autres avantages et caractéristiques pourront ressortir de la description détaillée qui suit.

### Description sommaire des dessins

L'invention sera mieux comprise à la lecture de la description détaillée qui suit, donnée uniquement à titre d'exemple non limitatif et faite en se référant aux dessins annexés et listés ci-dessous.
La figure 1 illustre, selon une vue en coupe, un dispositif piézoélectrique selon un exemple d'un premier mode de réalisation de l'invention.
La figure 2 illustre, selon une vue en coupe, le dispositif piézoélectrique selon un exemple d'un deuxième mode de réalisation de l'invention.
La figure 3 illustre, selon une vue en coupe, le dispositif piézoélectrique selon un exemple d'un troisième mode de réalisation de l'invention.
La figure 4 illustre, selon une vue en coupe, le résultat d'une étape de formation de nano-objets allongés piézoélectriques au cours de la fabrication du dispositif piézoélectrique.
La figure 5 illustre, selon une vue en coupe, le résultat d'une étape de formation d'une première couche d'un premier matériau au cours de la fabrication du dispositif piézoélectrique.
La figure 6 illustre, selon une vue en coupe, le résultat d'une étape de formation d'une deuxième couche d'un deuxième matériau au cours de la fabrication du dispositif piézoélectrique selon le premier mode de réalisation.
La figure 7 illustre, selon une vue en coupe, le résultat d'une étape de formation de la deuxième couche au cours de la fabrication du dispositif piézoélectrique selon le deuxième mode de réalisation.
La figure 8 illustre, selon une vue en coupe, comment peuvent être formées la deuxième couche et une troisième couche du dispositif piézoélectrique en vue de former le dispositif piézoélectrique selon le troisième mode de réalisation.
La figure 9 illustre, selon une vue en coupe, une variante du dispositif piézoélectrique selon le premier mode de réalisation.
La figure 10 illustre, selon une vue en coupe, une variante du premier mode de réalisation, selon cette variante le dispositif piézoélectrique comporte des nanofils à structure coeur-coquille.
La figure 11 illustre, selon une vue en coupe, une variante du deuxième mode de réalisation, selon cette variante le dispositif piézoélectrique comporte des nanofils à structure coeur-coquille.
La figure 12 illustre, selon une vue en coupe, une variante du troisième mode de réalisation, selon cette variante le dispositif piézoélectrique comporte des nanofils à structure coeur-coquille.

Sur ces figures, les mêmes références sont utilisées pour désigner les mêmes éléments.

### Description détaillée

Par « compris entre deux valeurs », il est entendu que les bornes définies par ces deux valeurs sont incluses dans la plage de valeurs considérée.

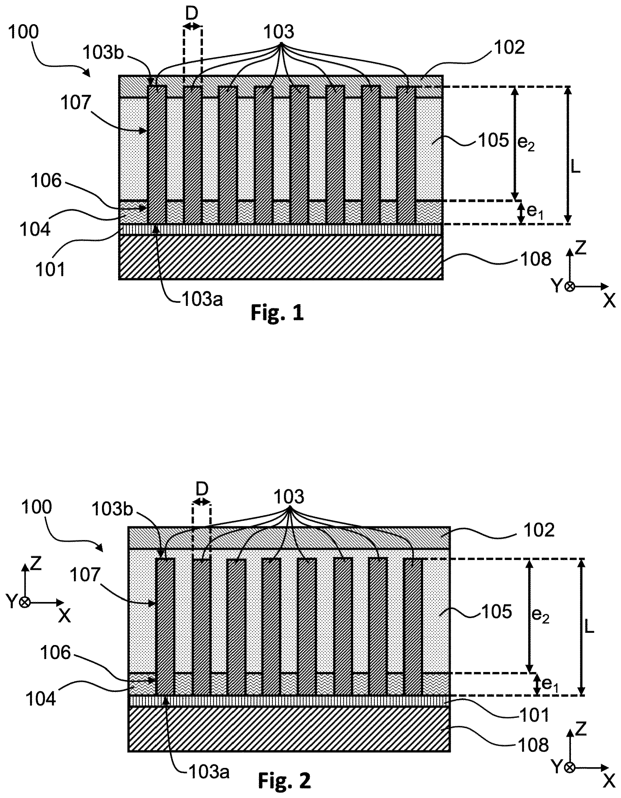

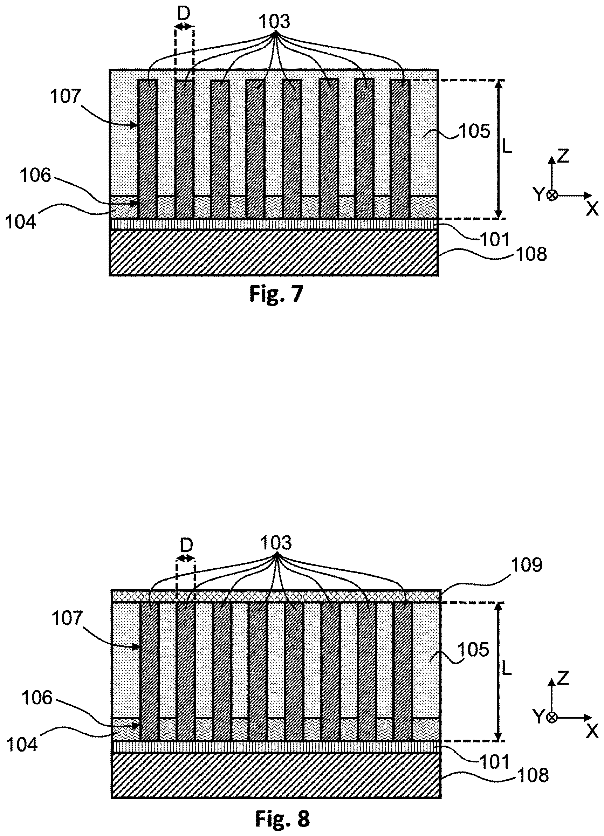

Pour les besoins de la présente description, il est à présent défini un repère orthonormé d'axes X, Y, et Z, ci-après dénommé repère XYZ, représentant le référentiel du dispositif 100 piézoélectrique, ce repère XYZ est représenté en figures 1 à 12. Notamment, les notions d'inférieur et de supérieur sont données selon l'axe Z qui est orienté vers le haut.

Par « quelques » suivi d'une grandeur (comme par exemple quelques nanomètres, quelques dizaines de nanomètres ou quelques centaines de nanomètres), il est préférentiellement entendu dans la présente description que la valeur correspondante (celle de la grandeur considérée associée à « quelques ») peut être comprise entre une valeur strictement supérieure à une fois la grandeur et une valeur égale à neuf fois la grandeur. En ce sens, par exemple, par quelques dizaines de nanomètres (nm), il peut être entendu une valeur strictement supérieure à 10 nanomètres et inférieure ou égale à 90 nanomètres.

Le dispositif 100 piézoélectrique, dont des exemples de premier, deuxième et troisième modes de réalisations sont représentés respectivement en figures 1 à 3, comporte une première électrode 101, une deuxième électrode 102 et des nano-objets 103 allongés piézoélectriques.

Dans le domaine, la première électrode 101 est communément appelée électrode inférieure et la deuxième électrode 102 est communément appelée électrode supérieure. Typiquement, chacune des première et deuxième électrodes 101, 102 peut présenter une épaisseur comprise entre quelques nanomètres et quelques centaines de nanomètres. De préférence, la deuxième électrode 102 est agencée en regard de la première électrode 101 et par exemple est agencée à l'aplomb de cette première électrode 101 comme le montrent les figures 1 à 3 dans le référentiel du repère XYZ.

Les nano-objets 103 allongés piézoélectriques forment notamment un réseau de nano-objets. Les nano-objets 103 allongés piézoélectriques sont en contact avec la première électrode 101. Les nano-objets 103 allongés piézoélectriques s'étendent entre la première électrode 101 et la deuxième électrode 102.

Le dispositif 100 piézoélectrique comporte une première couche 104 d'un premier matériau et une deuxième couche 105 d'un deuxième matériau. Le premier matériau est électriquement isolant, et le deuxième matériau est électriquement isolant, en ce sens les première et deuxième couches 104, 105 sont électriquement isolantes. La première couche 104 entoure une première portion 106 longitudinale de chacun des nano-objets 103 allongés piézoélectriques. La deuxième couche 105 entoure une deuxième portion 107 longitudinale de chacun des nano-objets 103 allongés piézoélectriques. La première couche 104 est agencée entre la première électrode 101 et la deuxième couche 105. Il en résulte que les première et deuxième couches 104, 105 sont agencées entre les première et deuxième électrodes 101, 102. Le premier matériau présente un module de Young strictement supérieur au module de Young du deuxième matériau, et l'épaisseur de la première couche 104 est strictement inférieure à l'épaisseur de la deuxième couche 105. La condition quant aux épaisseurs des première et deuxième couches 104, 105 présente l'avantage de limiter l'épaisseur de la première couche 104 par exemple à celle nécessaire pour obtenir une bonne tenue des nano-objets 103 allongés piézoélectriques via cette première couche 104 et l'avantage d'assurer le maintien de ces nano-objets 103 allongés piézoélectriques à la première électrode 101 et, le cas échéant, à un substrat 108 notamment sur lequel peut être agencée la première électrode 101. Ainsi, la première couche 104 assure un maintien mécanique des nano-objets 103 allongés piézoélectriques et est notamment configurée pour : consolider le réseau de nano-objets 103 allongés piézoélectriques à la base de chacun des nano-objets 103 allongés piézoélectriques notamment pour éviter leur arrachement par rapport à la première électrode 101 et le cas échéant par rapport au substrat 108 ; et assurer l'intégrité des nano-objets 103 allongés piézoélectriques en stabilisant leur alignement. La deuxième couche 105 présente l'avantage d'autoriser un maintien des nano-objets 103 allongés piézoélectriques tout en permettant leur déformation lors de l'utilisation du dispositif 100 piézoélectrique. Ainsi, les première et deuxième couches 104, 105 présentent l'avantage d'assurer une tenue satisfaisante des nano-objets 103 allongés piézoélectriques au niveau de leur première portion 106 longitudinale tout en permettant de favoriser la déformation des nano-objets 103 allongés piézoélectriques au niveau de leur deuxième portion 107 longitudinale et l'avantage d'éviter toute mise en contact directe entre les nano-objets 103 allongés piézoélectriques par exemple :
- lorsque le dispositif 100 piézoélectrique est soumis à une sollicitation pour permettre la génération d'une différence de potentiel au sein des nano-objets 103 allongés piézoélectriques impactés par cette sollicitation, ou
- lorsque les première et deuxième électrodes 101, 102 du dispositif 100 piézoélectrique sont utilisées pour soumettre les nano-objets 103 allongés piézoélectriques à un champ électrique pour les déformer volontairement.

Il en résulte que le dispositif 100 piézoélectrique présente une meilleure robustesse tout en présentant une efficacité satisfaisante.

Notamment, la première couche 104 est en contact avec les premières portions 106 longitudinales qu'elle entoure. Autrement dit, la première couche 104 enrobe les premières portions 106 longitudinales.

Notamment, la deuxième couche 105 est en contact avec les deuxièmes portions 107 longitudinales qu'elle entoure. Autrement dit, la deuxième couche 105 enrobe les deuxièmes portions 107 longitudinales.

Ainsi, les première et deuxième couches 104, 105 peuvent former deux matrices distinctes participant chacune au maintien mécanique des nano-objets 103 allongés piézoélectriques. Ces deux matrices distinctes sont superposées et présentent des propriétés mécaniques différentes.

La première couche 104 et la deuxième couche 105 peuvent présenter des dimensions latérales, mesurées orthogonalement à l'axe Z c'est-à-dire orthogonalement à la direction d'épaisseur de la première couche 104 et à la direction d'épaisseur de la deuxième couche 105, similaires ou identiques.

Les première et deuxième couches 104, 105 sont notamment empilées et en contact. Ainsi, la deuxième couche 105 est, de préférence, agencée sur la première couche 104. Dans ce cas, pour chaque nano-objet 103 allongé piézoélectrique, sa deuxième portion 107 longitudinale est agencée dans le prolongement de sa première portion 106 longitudinale. Ceci permet de maîtriser l'isolation électrique des nano-objets 103 allongés piézoélectriques selon leur longueur.

Les nano-objets 103 allongés piézoélectriques sont préférentiellement dits « intégrés verticalement » dans le sens où, dans le repère XYZ, la direction d'allongement de chacun des nano-objets 103 allongés piézoélectriques est préférentiellement verticale et parallèle à l'axe Z. Dans ce cas, les première et deuxième électrodes 101, 102 sont dites « horizontales » dans le repère XYZ et sont agencées chacune dans un plan parallèle au plan défini par les axes X et Y.

Chaque nano-objet 103 allongé piézoélectrique peut comporter, comme notamment visible aux figures 1 à 3 :
- une première extrémité 103a longitudinale en contact avec la première électrode 101 notamment au niveau de la base évoquée ci-avant dudit nano-objet 103 allongé piézoélectrique, de préférence la première portion 106 longitudinale du nano-objet 103 allongé piézoélectrique s'étend depuis la première extrémité 103a longitudinale vers la deuxième électrode 102,
- une deuxième extrémité 103b longitudinale opposée à la première extrémité 103a longitudinale et située à une distance, par rapport à la première électrode 101, égale à la longueur L du nano-objet 103 allongé piézoélectrique considéré. Autrement dit, pour chaque nano-objet 103 allongé piézoélectrique, ses première et deuxième extrémités 103a, 103b longitudinales sont opposées dans la direction longitudinale dudit nano-objet 103 allongé piézoélectrique, la deuxième extrémité 103b longitudinale étant à proximité de la deuxième électrode 102 alors que la première extrémité 103a longitudinale est en contact avec la première électrode 101.

Dans la présente description, chaque nano-objet 103 allongé piézoélectrique présente, outre sa longueur L, une dimension D transversale maximale strictement inférieure à sa longueur L (figures 1 à 12). La longueur L de chaque nano-objet 103 allongé piézoélectrique peut être comprise entre 100 nm et 10 µm. En particulier, la dimension D transversale maximale de chaque nano-objet 103 allongé piézoélectrique, aussi appelée diamètre dans le domaine technique de l'invention est à l'échelle nanométrique. Ainsi, la dimension D transversale maximale peut être comprise entre quelques nanomètres et quelques centaines de nanomètres. Préférentiellement, la dimension D transversale maximale de chacun des nano-objets 103 allongés piézoélectriques est inférieure ou égale à 500 nm.

Les nano-objets 103 allongés piézoélectriques peuvent être des nanofils ou des nanotubes. Les nanofils peuvent être des nanofils « simples » c'est-à-dire formant chacun un élément allongé formé d'un seul matériau comme un nanofil de nitrure de gallium (tel qu'un nanofil de GaN) ou un nanofil d'oxyde de zinc (tel qu'un nanofil de ZnO), ou être des nanofils présentant une structure coeur-coquille. Ce type de structure coeur-coquille permet d'augmenter encore l'énergie produite par le nano-générateur par rapport à une structure à nanofils « simple ».

Par « nano-objet 103 allongé piézoélectrique », il est entendu que le nano-objet 103 allongé piézoélectrique comporte un matériau piézoélectrique tel que par exemple le nitrure de gallium ou l'oxyde de zinc. En particulier, le nano-objet 103 allongé piézoélectrique est formé en tout ou partie par ce matériau piézoélectrique. Ainsi, le nano-objet 103 allongé piézoélectrique permet, lorsqu'il est soumis à une sollicitation entraînant sa déformation, d'obtenir au sein du nano-objet 103 allongé piézoélectrique une différence de potentiel permettant de générer un signal électrique. Bien entendu, réciproquement, si un champ électrique adapté est appliqué aux nano-objets 103 allongés piézoélectriques par les première et deuxième électrodes 101, 102, alors les nano-objets 103 allongés piézoélectriques se déformeront.

Les nano-objets 103 allongés piézoélectriques présentent chacun une structure cristalline hexagonale de type wurtzite telle que la réponse piézoélectrique dudit nano-objet 103 allongé piézoélectrique est la plus importante dans la direction <0001> (correspondant notamment au coefficient piézoélectrique d₃₃) aussi appelée « axe C ».

De préférence, les nano-objets 103 allongés piézoélectriques sont des nanofils d'oxyde de zinc ou de nitrure de gallium, de tels nanofils sont des nanofils « simple » comme évoqué ci-avant. De tels nanofils présentent l'avantage d'avoir une structure cristalline de type wurtzite de sorte à obtenir, pour chacun des nanofils, la réponse piézoélectrique évoquée ci-dessus. Ces nanofils étant préférentiellement obtenus par croissance, chaque nanofil présente l'avantage que sa croissance s'effectue spontanément dans la direction <0001> qui correspond alors à l'axe longitudinal dudit nanofil. De préférence, les axes longitudinaux des nanofils sont sensiblement verticaux (dans le référentiel du dispositif 100 piézoélectrique) avec un angle par rapport à la normale au plan du substrat 108 strictement inférieur à 25 degré. Avantageusement les axes longitudinaux des nanofils sont orthogonaux aux plans des première et deuxième couches 104, 105, aux plans des première et deuxième électrodes 101, 102, et, le cas échéant, au plan du substrat 108 du dispositif 100 piézoélectrique sur lequel sont empilées successivement la première électrode 101, la première couche 104, la deuxième couche 105, et la deuxième électrode 102.

De préférence, chaque nano-objet 103 allongé piézoélectrique présente un rapport de forme égal à L/D, avec L étant la longueur dudit nano-objet 103 allongé piézoélectrique et D étant la dimension transversale maximale dudit nano-objet 103 allongé piézoélectrique comme évoqué ci-avant. Ce rapport de forme est supérieur ou égal à 5 et la dimension D transversale maximale de chacun des nano-objets 103 allongés piézoélectrique est inférieure ou égale à 500 nm et avantageusement inférieure ou égale à 50 nm en vue d'exacerber l'effet piézoélectrique du nano-objet 103 allongé piézoélectrique considéré. L'expression analytique connue de l'expression du potentiel généré par un nano-objet 103 allongé piézoélectrique montre que ce potentiel est proportionnel au rapport L/D et inversement proportionnel à D. Il y a donc un avantage à avoir des nano-objets 103 allongés piézoélectriques présentant une dimension D maximale latérale la plus petite possible et une longueur L la plus grande possible comme le montre par exemple le document « Performance Optimization of Vertical Nanowire-based Piezoelectric Nanogenerators » de Hinchet et al. publié dans Advanced Functional Materials 2014, 24, 971-977.

La première électrode 101 peut être formée d'au moins une couche métallique ou d'une couche semi-conductrice dopée permettant, selon l'utilisation du dispositif 100 piézoélectrique :
- d'assurer la récupération de charges électriques si le dispositif 100 piézoélectrique est soumis à une sollicitation permettant l'obtention d'une différence de potentiel électrique dans un ou plusieurs nano-objets 103 allongés piézoélectriques, ou
- de participer avec la deuxième électrode 102 à soumettre les nano-objets 103 allongés piézoélectriques à un champ électrique en vue de les déformer.

Selon un exemple particulier non représenté sur les figures, la première électrode 101 peut être formée par un empilement de première et deuxième couches métalliques. La première couche métallique peut être au contact du substrat 108 pour favoriser l'accroche de la deuxième couche métallique et donc ancrer la deuxième couche métallique par rapport au substrat 108. Dans ce cas la première couche métallique peut être une couche de titane, de chrome ou de nitrure de titane, et la première couche métallique peut présenter une épaisseur de quelques dizaines de nanomètres. La deuxième couche métallique peut être une couche d'or, ou de platine, et la deuxième couche métallique peut présenter une épaisseur comprise entre quelques dizaines de nanomètres et quelques centaines de nanomètres. Cette deuxième couche métallique, agencée sur la première couche métallique et au contact des nano-objets 103 allongés piézoélectriques, est adaptée pour assurer une fonction de conductivité électrique souhaitée et aussi pour servir de couche de nucléation des nano-objets 103 allongés piézoélectriques lors de la fabrication du dispositif 100 piézoélectrique.

L'interface entre la première électrode 101 et les nano-objets 103 allongés piézoélectriques peut être soit de type ohmique soit de type Schottky. Pour des nano-objets 103 allongés piézoélectriques formés par des nanofils d'oxyde de zinc, la première électrode 101, de préférence monocristalline, peut être formée par :
- une couche d'oxyde de zinc de préférence monocristallin, une couche d'oxyde de zinc, de préférence monocristallin, dopé à l'aluminium aussi connu sous le sigle AZO et pour laquelle le dopage peut être réalisé au moins sur une certaine profondeur, une couche d'oxyde d'indium dopé à l'étain aussi connu sous le sigle ITO, ou une couche d'oxyde d'étain dopé au fluor (aussi connu sous le sigle FTO) de sorte que la première électrode 101 forme un contact ohmique avec les nano-objets 103 allongés piézoélectriques, ou
- une couche d'or ou une couche de platine de sorte que la première électrode 101 forme un contact Schottky avec les nano-objets 103 allongés piézoélectriques. Pour des nano-objets 103 allongés piézoélectriques formés par des nanofils de nitrure de gallium dopé N ou P, la première électrode 101 peut être formée par une couche de nitrure de gallium ou une couche de nitrure de titane de sorte à former un contact ohmique, ou un contact Schottky, avec les nano-objets 103 allongés piézoélectriques suivant le type N ou P du dopage du nitrure de gallium des nanofils.

Préférentiellement, l'interface entre la première électrode 101 et les nano-objets 103 allongés piézoélectriques est de type Schottky en vue d'éviter le passage d'un courant au travers des nano-objets 103 allongés piézoélectriques lors du fonctionnement du dispositif 100 piézoélectrique.

Par « interface entre une électrode, que cela soit la première électrode 101 ou, le cas échéant, la deuxième électrode 102, et les nano-objets 103 allongés piézoélectriques » il est entendu le contact, ou la surface de contact, entre l'électrode et les nano-objets 103 allongés piézoélectriques. Lorsque cette interface est de type ohmique elle forme un contact ohmique, et lorsque cette interface est de type Schottky elle forme un contact Schottky.

La deuxième électrode 102 peut comporter au moins une couche métallique ou une couche semi-conductrice dopée permettant :
- d'assurer la récupération de charges électriques si le dispositif 100 piézoélectrique est soumis à une sollicitation permettant l'obtention d'une différence de potentiel électrique dans un ou plusieurs nano-objets 103 allongés piézoélectriques, ou
- de participer avec la première électrode 101 à soumettre les nano-objets 103 allongés piézoélectriques à un champ électrique en vue de les déformer.

De manière générale, les première et deuxième électrodes 101, 102 sont agencées de sorte qu'il n'y ait pas de courant qui traverse les nano-objets 103 allongés piézoélectriques, c'est pour cela que le contact de la première électrode 101 avec les nano-objets 103 allongés piézoélectriques est de préférence un contact Schottky. Si les première et deuxième électrodes 101, 102 sont en contact avec les nano-objets 103 allongés piézoélectriques, au moins l'un de ces contacts est un contact Schottky pour éviter qu'un courant électrique ne vienne s'établir dans les nano-objets 103 allongés piézoélectriques d'où il résulterait l'impossibilité d'obtenir un effet piézoélectrique via ces nano-objets 103 allongés piézoélectriques.

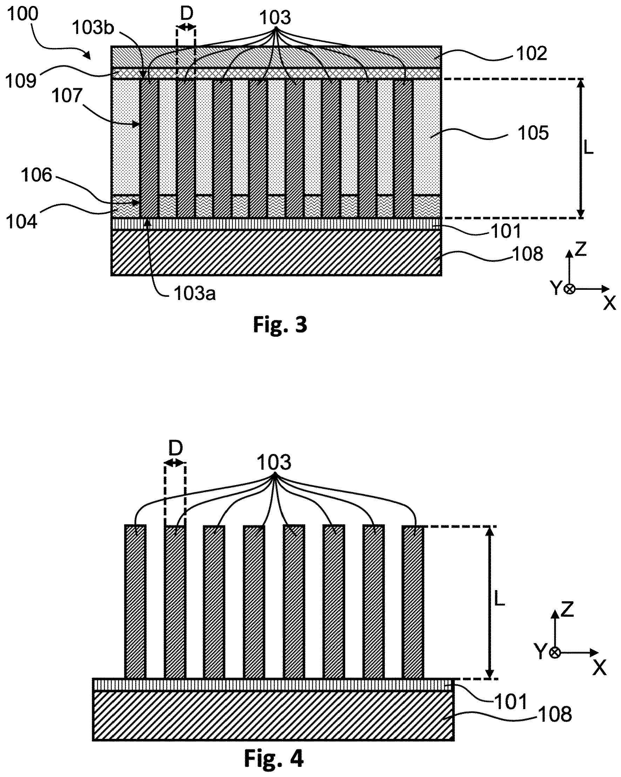

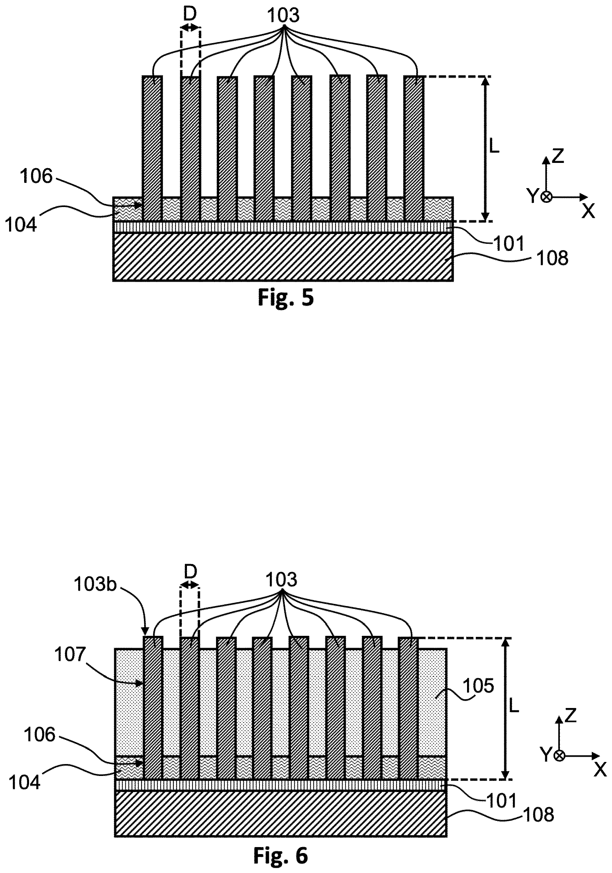

L'invention est aussi relative à un procédé de fabrication du dispositif 100 piézoélectrique dont des étapes sont illustrées à titre d'exemple en figures 4 à 8. Le procédé de fabrication comporte une étape de formation des nano-objets 103 allongés piézoélectriques sur la première électrode 101 comme le montre par exemple la figure 4. Le procédé de fabrication comporte, comme par exemple illustré en figure 5, une étape de formation de la première couche 104 par exemple par dépôt du premier matériau. Cette étape de formation de la première couche 104 est mise en oeuvre de telle sorte que la première couche 104 formée entoure une première portion 106 longitudinale de chacun des nano-objets 103 allongés piézoélectriques. Le procédé de fabrication comporte aussi une étape de formation de la deuxième couche 105, par exemple par dépôt du deuxième matériau, de telle sorte que la deuxième couche 105 formée entoure la deuxième portion 107 longitudinale de chacun des nano-objets 103 allongés piézoélectriques (trois mises en oeuvre différentes de la formation de cette deuxième couche 105 sont illustrées respectivement en figures 6, 7 et 8). Le procédé de fabrication comporte aussi une étape de formation de la deuxième électrode 102, par exemple par dépôt, la deuxième électrode 102 formée étant agencée de sorte que les nano-objets 103 allongés piézoélectriques s'étendent entre la première électrode 101 et la deuxième électrode 102 (comme le montre par exemples les figures 1 à 3). Bien entendu, le procédé de fabrication est tel que la première couche 104 est agencée entre la première électrode 101 et la deuxième couche 105, et que l'épaisseur de la première couche 104 formée est strictement inférieure à l'épaisseur de la deuxième couche 105 formée. Un tel procédé de fabrication est facile à mettre en oeuvre et permet d'obtenir le dispositif 100 piézoélectrique à la fois robuste et déformable. Bien entendu, l'étape de formation de la deuxième couche 105 est réalisée avant l'étape de formation de la deuxième électrode 102. Ce qui s'applique pour le dispositif piézoélectrique s'applique bien entendu au procédé de fabrication et vice versa.

Le dépôt du premier matériau et le dépôt du deuxième matériau peuvent être mis en oeuvre chacun par étalement (« spin coating » en langue anglaise), par dépôt physique par phase vapeur aussi connu sous le sigle « PVD » correspondant à « physical vapor déposition » en langue anglaise, par CVD, ou par dépôt de couche atomique aussi connu sous le sigle « ALD » correspondant à « atomic layer déposition » en langue anglaise.

En particulier, le dispositif 100 piézoélectrique comporte le substrat 108 évoqué précédemment et représenté aux figures 1 à 8. Sur ce substrat 108 est agencée la première électrode 101 et notamment au moins une couche formant cette première électrode 101. On dit alors que les nano-objets 103 allongés piézoélectriques sont solidaires, c'est-à-dire accrochés, à ce substrat 108 notamment via la première électrode 101.

Le substrat 108 peut être un substrat rigide en silicium par exemple, ou encore en verre, en saphir ou en oxyde de zinc monocristallin. Avantageusement, le substrat 108 est une tranche de silicium, aussi appelée dans le domaine « wafer » en langue anglaise. Le substrat 108 peut aussi être un substrat flexible (par exemple en polytéréphtalate d'éthylène aussi connu sous le sigle PET, en polyimide, en Kapton^{®} qui correspond à un film de polyimide développé par la société DuPont, en polyméthacrylate de méthyle aussi connue sous le sigle PMMA ou en polydiméthylsiloxane aussi connu sous le sigle PDMS) si une croissance de matériau à basse température, typiquement inférieure ou égale à 200°C, est mise en oeuvre en vue de former les nano-objets 103 allongés piézoélectriques. Une telle croissance à basse température peut être mise en oeuvre avantageusement par dépôt en bain chimique. Par exemple, la croissance des nanofils d'oxyde de zinc en tant que nano-objets 103 allongés piézoélectriques peut être réalisée à basse température inférieure ou égale à 100°C.

De préférence, le procédé de fabrication est tel que la première électrode 101 est déposée sous la forme d'une ou de plusieurs couches sur le substrat 108 avant l'étape de formation, en particulier par croissance, des nano-objets 103 allongés piézoélectriques. Dans ce cas, la face de la première électrode 101 à l'opposé du substrat 108 est formée d'un matériau métallique ou semi-conducteur permettant de favoriser la nucléation des nano-objets 103 allongés piézoélectriques tout en permettant d'assurer par la suite, par exemple, la fonction d'électrode lors de l'utilisation du dispositif 100 piézoélectrique.

Ainsi, la première électrode 101 comporte, de préférence, une surface permettant une croissance, notamment orthogonale au plan de la première électrode 101, des nano-objets 103 allongés piézoélectriques. Pour cela, cette surface peut être délimitée par une couche déposée présentant une structure cristalline cubique texturée selon l'axe <111> comme par exemple une couche d'or. Les matériaux possibles de la première électrode 101, et évoqués précédemment pour que la première électrode 101 forme un contact ohmique ou un contact Schottky avec les nanofils d'oxyde de zinc ou de nitrure de gallium dopé N ou P, peuvent être utilisés pour la nucléation de ces nanofils.

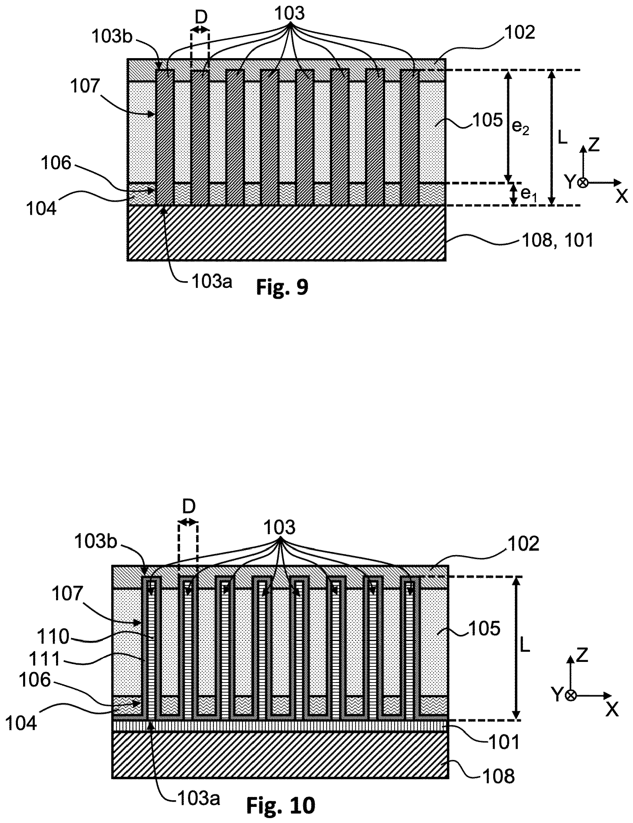

Selon une variante représentée en figure 9, si le substrat 108 est dans un matériau autorisant la nucléation des nano-objets 103 allongés piézoélectriques, il peut former la première électrode 101. Pour cela, le substrat 108 peut être formé par de l'oxyde de zinc monocristallin. Dans ce cas les nano-objets 103 allongés piézoélectriques peuvent pousser directement sur le monocristal de ZnO orienté <0001>. Bien que le substrat 108, servant aussi de première électrode 101 en figure 9, soit utilisé dans le premier mode de réalisation du type de la figure 1, il peut aussi être utilisé dans les exemples des deuxième et troisième modes de réalisations en fusionnant les éléments référencés 101 et 108 aux figures 2 et 3.

La croissance des nano-objets 103 allongés piézoélectriques peut être réalisée depuis la première électrode 101. Selon une réalisation, cette croissance peut être réalisée à l'aide d'un masque temporaire agencé sur la première électrode 101, ce masque temporaire comportant alors des trous débouchants qui débouchent sur la première électrode 101 permettant ainsi la croissance contrôlée des nano-objets 103 allongés piézoélectriques depuis la première électrode 101 et au travers du masque temporaire. Le masque temporaire peut être réalisé par une technique de lithographie conventionnelle ou en origami d'ADN (sigle d'Acide DésoxyriboNucléique) pour lequel il est possible d'obtenir des tailles de motifs de quelques nanomètres. Bien entendu ce masque temporaire est retiré avant de former la première couche 104.

De préférence, le module de Young du premier matériau est supérieur ou égal à 5 GPa et encore plus préférentiellement le module de Young du premier matériau est supérieur ou égal à 25 GPa. Ceci permet d'obtenir une tenue convenable des nano-objets 103 allongés piézoélectriques entre eux et notamment par rapport à la première électrode 101.

Pour former, et en particulier constituer, la première couche 104, le premier matériau peut être choisi parmi : un silsesquioxane d'hydrogène (aussi connu sous le sigle HSQ) par exemple ayant subi un recuit à une température supérieure ou égale à 250°C et avantageusement supérieure ou égale à 350°C (le recuit pouvant être réalisé pendant quelques minutes sous air), le dioxyde de silicium tel que SiO₂ ou ses dérivés non-stoechiométriques, l'alumine telle que Al₂O₃ ou ses dérivés non-stoechiométriques, et un nitrure de silicium tel que Si₃N₄ ou ses dérivés non-stoechiométriques. De tels matériaux présentent un module de Young adapté pour assurer la fonction de matrice rigide pour le maintien des nano-objets 103 allongés piézoélectriques. Le silsesquioxane d'hydrogène ayant subi un recuit à une température supérieure ou égale à 350°C peut présenter un module de Young compris entre 5 GPa et 80 GPa. Le dioxyde de silicium peut présenter un module de Young compris entre 46 GPa et 92 GPa. L'alumine peut présenter un module de Young compris entre 300 GPa et 530 GPa. Le nitrure de silicium peut présenter un module de Young compris entre 100 GPa et 325 GPa.

De préférence, le module de Young du deuxième matériau est strictement inférieur à 5 GPa et encore plus préférentiellement le module de Young du deuxième matériau est inférieur ou égal à 3 GPa. Ceci permettant de renforcer la stabilité mécanique des nano-objets 103 allongés piézoélectriques et donc du réseau de nano-objets, tout en conférant une liberté de déformation à chacun de ces nano-objets 103 allongés piézoélectriques et donc au réseau de nano-objets lors de l'utilisation du dispositif 100 piézoélectrique.

Pour former, et en particulier constituer, la deuxième couche 105 le deuxième matériau peut être choisi parmi : un polyméthacrylate de méthyle (aussi connu sous le sigle PMMA), un silsesquioxane d'hydrogène par exemple ayant subi un recuit à une température strictement inférieure à 250°C et réalisé pendant quelques minutes sous air, une résine SU-8, un polydiméthylsiloxane (aussi connu sous le sigle PDMS) qui peut par exemple être non traité ou être traité sous plasma oxygène, un parylène C, et une résine à base d'un polymère organique et contenant du silicium. De tels matériaux présentent un module de Young adapté pour former la deuxième couche 105.

Le polyméthacrylate de méthyle peut présenter un module de Young de l'ordre de 2,5 GPa. Le silsesquioxane d'hydrogène ayant subi un recuit à une température strictement inférieure à 250°C peut présenter un module de Young strictement inférieur à 5 GPa. La résine SU-8 peut présenter un module de Young de l'ordre de 2,2 GPa. Le PDMS non traité peut présenter un module de Young de l'ordre de 2 MPa. Le PDMS traité sous plasma oxygène peut présenter un module de Young pouvant aller jusqu'à 1,5 GPa. Le parylène C peut présenter un module d'Young de l'ordre de 2,5 GPa. Dans le présent paragraphe, par « de l'ordre d'une valeur » il est entendu cette valeur à plus ou moins 20 %.

La résine SU-8 est une résine photosensible négative. Il peut être utilisé une résine SU-8 issue des séries SU-8 2000 par exemple de la société Kayaku Advanced Materials ou une résine SU-8 GM 10xx de la société Gersteltec Engineering Solutions.

Concernant les premier et deuxième matériaux définis précédemment, il est notamment entendu qu'au sein du dispositif 100 piézoélectrique :
- chacun des premier et deuxième matériaux est dépourvu de solvant qui peut, lorsque le solvant est présent initialement dans le matériau concerné, avoir été évaporé totalement, par exemple par traitement thermique, lors de la fabrication du dispositif 100 piézoélectrique,
- les premier et deuxième matériaux sont chacun dans un état au moins partiellement réticulé par traitement thermique réalisé au cours de la fabrication du dispositif 100 piézoélectrique.

De préférence, l'épaisseur de la première couche 104 est inférieure ou égale à 20 %, et avantageusement inférieure ou égale à 5 %, de la longueur L des nano-objets 103 allongés piézoélectriques. Ceci présente l'avantage technique d'assurer une tenue convenable des nano-objets 103 allongés piézoélectrique notamment par rapport à la première électrode 101 au niveau de laquelle est agencée la première couche 104, tout en laissant une partie plus longue de chacun des nano-objets 103 allongés piézoélectriques, non maintenue par cette première couche 104, susceptible de se déformer lors de l'utilisation du dispositif 100 piézoélectrique. L'épaisseur de la première couche 104 peut être supérieure ou égale à 5 nm.

Selon le premier mode de réalisation, tel que par exemple illustré en figures 1 et 9, la longueur L de chacun des nano-objets 103 allongés piézoélectriques est strictement supérieure à la somme de l'épaisseur e₁ de la première couche 104 et de l'épaisseur e₂ de la deuxième couche 105. La structure du dispositif 100 piézoélectrique selon ce premier mode réalisation est une structure Schottky, la structure Schottky présente l'avantage d'avoir une impédance la plus faible. Selon ce premier mode de réalisation, la première électrode 101 et la deuxième électrode 102 sont chacune en contact avec les nano-objets 103 allongés piézoélectriques. Dès lors, au moins l'une des première et deuxième électrodes 101, 102 forme un contact Schottky avec les nano-objets allongés 103 piézoélectriques.

Pour obtenir le dispositif 100 piézoélectrique selon ce premier mode de réalisation, l'étape de formation de la deuxième couche 105 est telle qu'elle laisse accessible les deuxièmes extrémités 103b longitudinales des nano-objets 103 allongés piézoélectriques en vue d'autoriser la formation de la deuxième électrode 102 au contact de ces deuxièmes extrémités 103b longitudinales. Autrement dit, au terme de la formation de la deuxième couche 105, des parties de chacun des nano-objets 103 allongés piézoélectriques dépassent de la deuxième couche 105 comme le montre par exemple la figure 6. Ensuite, la deuxième électrode 102 est formée sur la deuxième couche 105 et en contact avec les parties des nano-objets 103 allongés piézoélectriques dépassant de la deuxième couche 105 comme le montre la figure 1.

Selon le premier mode de réalisation, il est possible de distinguer deux cas :
- si l'interface entre la première électrode 101 et les nano-objets 103 allongés piézoélectriques est de type ohmique alors l'interface entre les nano-objets 103 allongés piézoélectriques et la deuxième électrode 102 est obligatoirement de type Schottky,
- si l'interface entre la première électrode 101 et les nano-objets 103 allongés piézoélectriques est de type Schottky, alors l'interface entre les nano-objets 103 allongés piézoélectriques et la deuxième électrode 102 peut être de type ohmique ou de type Schottky.

Préférentiellement, selon ce premier mode de réalisation, la première électrode 103 forme un contact Schottky avec les nano-objets 103 allongés piézoélectriques et la deuxième électrode 102 forme un contact Schottky avec les nano-objets 103 allongés piézoélectriques. Ceci présente les avantages suivants : avoir deux contacts Schottky, éviter les courants de fuite et avoir une impédance minimale en comparaison à celle du dispositif 100 piézoélectrique à structure capacitive ou à structure capacitive optimisée comme décrit ci-après.

Par exemple, dans le premier mode de réalisation, si les nano-objets 103 allongés piézoélectriques sont des nanofils d'oxyde de zinc ou de nitrure de gallium, et si la première électrode 101 forme un contact ohmique avec les nano-objets 103 allongés piézoélectriques, alors la deuxième électrode 102 peut être en or, en palladium ou en platine de sorte à ce que cette deuxième électrode 102 forme un contact de Schottky avec les nano-objets 103 allongés piézoélectriques.

Par exemple, dans le premier mode de réalisation, si les nano-objets 103 allongés piézoélectriques sont des nanofils d'oxyde de zinc ou de nitrure de gallium, et si la première électrode 101 forme un contact de Schottky avec les nano-objets 103 allongés piézoélectriques, alors la deuxième électrode 102 peut former un contact ohmique ou un contact Schottky avec les nano-objets 103 allongés piézoélectriques, dans ce cas la deuxième électrode 102 peut être :
- en aluminium de sorte à ce que cette deuxième électrode 102 forme un contact ohmique avec les nano-objets 103 allongés piézoélectriques, ou
- en or, en palladium ou en platine de sorte à ce que cette deuxième électrode 102 forme un contact de Schottky avec les nano-objets 103 allongés piézoélectriques.

Selon le deuxième mode de réalisation, tel que par exemple illustrée en figure 2, la longueur L de chacun des nano-objets 103 allongés est strictement inférieure à la somme de l'épaisseur e₁ de la première couche 104 et de l'épaisseur e₂ de la deuxième couche 105, la deuxième électrode 102 étant à distance des nano-objets 103 allongés piézoélectriques. Ceci présente l'avantage d'éviter les courants de fuite. Par ailleurs, ce dispositif 100 piézoélectrique du deuxième mode de réalisation présente l'avantage d'être simple à réaliser.

Ainsi, selon ce deuxième mode de réalisation, la deuxième extrémité 103b longitudinale de chacun des nano-objets 103 allongés piézoélectriques est enrobée par du deuxième matériau de la deuxième couche 105.

Dans le deuxième mode de réalisation, il n'y a pas de critère particulier sur la nature de l'interface entre la deuxième couche 105 et la deuxième électrode 102. Dès lors, la deuxième électrode 102 peut être formée par n'importe quel métal pouvant notamment être déposé par PVD.

Selon le troisième mode de réalisation, tel que par exemple illustré en figure 3, les premières extrémités 103a longitudinales des nano-objets 103 allongés piézoélectriques sont en contact avec la première électrode 101, et les deuxièmes extrémités 103b longitudinales des nano-objets 103 allongés piézoélectriques sont en contact avec une troisième couche 109 d'un matériau électriquement isolant aussi appelée couche 109 diélectrique. La troisième couche 109 relie les deuxièmes extrémités 103b longitudinales à la deuxième électrode 102. Cet agencement particulier comportant les première, deuxième et troisième couches 104, 105, 109 présente l'avantage d'obtenir une structure capacitive optimisée du dispositif 100 piézoélectrique, notamment en permettant d'améliorer la collecte de charges par la deuxième électrode 102 par rapport à la structure du deuxième mode de réalisation. Lorsque le dispositif 100 piézoélectrique est utilisé pour appliquer un champ électrique déformant les nano-objets 103 allongés piézoélectriques, la troisième couche 109 permet d'évite les courants de fuite. La troisième couche 109 peut être choisie pour optimiser la capacité électrique formée entre les deuxièmes extrémités 103b longitudinales des nano-objets 103 allongés piézoélectriques et la deuxième électrode 102, cette optimisation pouvant se faire en terme de choix de matériau formant la troisième couche 109 et d'épaisseur de la troisième couche 109. Bien entendu, la troisième couche 109 est dans un matériau différent du deuxième matériau et est en contact avec la deuxième couche 105.

Pour cette troisième réalisation, il n'y a pas de critère particulier sur la nature de l'interface entre la troisième couche 109 et la deuxième électrode 102. Dès lors, la deuxième électrode 101 peut être formée par n'importe quel métal pouvant notamment être déposé par PVD.

Le matériau électriquement isolant de la troisième couche 109 peut présenter une permittivité relative εᵣ élevée, c'est-à-dire supérieure ou égale à 3,9. En particulier, le matériau électriquement isolant de la troisième couche 109 peut être choisi parmi un oxyde d'aluminium comme l'alumine tel que Al₂O₃ ou ses dérivés non-stoechiométriques, un nitrure de silicium comme par exemple Si₃N₄ ou ses dérivés non-stoechiométriques, ou un oxyde d'hafnium tel que HfO₂ ou ses dérivés non-stoechiométriques. Ceci permettant notamment l'amélioration de la collecte de charges par la deuxième électrode 102 lors de l'utilisation du dispositif 100 piézoélectrique.

L'épaisseur de la troisième couche 109 peut être comprise entre 10 nm et 100 nm, cette épaisseur permettant notamment de réaliser l'optimisation évoquée précédemment.

Du fait de la présence de la troisième couche 109, et en particulier de sa permittivité relative, le contact Schottky entre les nano-objets 103 allongés piézoélectriques avec la première électrode 101 n'est pas nécessaire car la troisième couche 109 permet à elle seule d'éviter l'établissement d'un courant traversant les nano-objets 103 allongés piézoélectriques lors de l'utilisation du dispositif 100 piézoélectrique.

Dans les premier, deuxième et troisième modes de réalisation, la deuxième électrode 102 peut comporter deux couches successives (non représenté). Par exemple, la deuxième électrode 102 peut comporter une couche de titane ou de chrome sur laquelle est agencé une couche de métal comme par exemple une couche d'or ou n'importe quel métal pouvant être déposé par PVD. La couche de titane ou de chrome est plus proche de la première électrode 101 que la couche de métal. La couche de titane ou de chrome peut servir de couche d'accroche à la couche de métal déposée ensuite sur cette couche de titane ou de chrome. Par exemple, la couche de titane ou de chrome peut présenter une épaisseur comprise entre quelques nanomètres et 50 nm et la couche d'or peut présenter une épaisseur comprise entre quelques nanomètres et 100 nm. Notamment dans le premier mode de réalisation, l'une des deux couches successives de la deuxième électrode 102 est en contact avec les nano-objets 103 allongés piézoélectriques et détermine, par sa nature, si le contact entre les nano-objets 103 allongés piézoélectriques et la deuxième électrode 102 est un contact ohmique ou un contact Schottky.

Il résulte de ce qui a été décrit précédemment que l'épaisseur de la deuxième couche 105 dépend du mode de réalisation du dispositif 100 piézoélectrique. Par exemple, si la deuxième électrode 102 est en contact avec les nano-objets 103 allongés piézoélectriques (figure 1) alors la deuxième couche 105 peut être en retrait des deuxièmes extrémités 103b longitudinales d'une distance comprise entre quelques dizaines de nanomètres et 100 nm. Par exemple, si la deuxième couche 105 couvre les deuxièmes extrémités 103b longitudinales (figure 2), alors l'épaisseur de deuxième matériau dans la continuité des deuxièmes extrémités 103b longitudinales peut être comprise entre quelques dizaines de nanomètres et quelques centaines de nanomètres, ce surplus d'épaisseur permettant d'ajuster la capacité électrique du dispositif 100 piézoélectrique. Lorsque la troisième couche 109 est présente (figure 3), l'épaisseur de la deuxième couche 105 peut être telle que la deuxième couche 105 est en retrait des deuxièmes extrémités 103b longitudinales des nano-objets 103 allongés piézoélectriques de quelques nanomètres à quelques dizaines de nanomètres : dans ce cas, les nano-objets 103 allongés piézoélectriques dépassent chacun de la deuxième couche 105 de quelques nanomètres à quelques dizaines de nanomètres. Dans tous les cas, l'épaisseur de la deuxième couche 105 peut être ajustée après dépôt du deuxième matériau par gravure chimique, avantageusement par plasma, du deuxième matériau déposé.

Lorsque les nano-objets 103 allongés piézoélectriques ne présentent pas de structure coeur-coquille, ils peuvent chacun présenter un diamètre compris entre quelques dizaines de nanomètres et quelques centaines de nanomètres.

Comme évoqué précédemment, les nano-objets 103 allongés piézoélectriques peuvent être des nanofils présentant une structure coeur-coquille (figures 10 à 12). Ces nanofils à structure coeur-coquille comportent chacun une âme 110 formant le coeur de la structure coeur coquille et une couche 111 de passivation électrique couvrant l'âme et formant la coquille de la structure coeur coquille. Ainsi, chaque couche 111 de passivation est agencé sur une âme 110 correspondante. Ici, seule une partie de chacun des nano-objets 103 allongés piézoélectrique, formée par l'âme 110, est en matériau piézoélectrique. Ainsi, les âmes des nano-objets 103 allongés piézoélectriques peuvent être par exemple en nitrure de gallium ou en oxyde de zinc. Chaque couche 111 de passivation électrique est par exemple réalisée dans un, c'est-à-dire formée d'un, matériau de passivation électrique choisi parmi : un nitrure d'aluminium tel que AIN ou ses dérivés non stoechiométriques, un oxyde d'aluminium comme par exemple l'alumine telle que Al₂O₃ ou ses dérivés non stoechiométriques, un oxyde d'hafnium tel que HfO₂ ou ses dérivés non stoechiométriques, ou un oxyde de titane tel que TiO₂ ou ses dérivés non stoechiométriques. Chaque couche 111 de passivation peut présenter une épaisseur comprise entre quelques nanomètres et 100 nm. Chaque âme 110 peut présenter un diamètre compris entre quelques dizaines de nanomètres et quelques centaines de nanomètres. Notamment, l'âme 110 de chacun des nano-objets 103 allongés piézoélectriques est en contact avec la première électrode 101 comme il est possible de le voir sur les figures 10 à 12 qui représentent respectivement les figures 1 à 3 mais pour lesquelles les nano-objets 103 allongés piézoélectriques sont représentés chacun sous la forme d'un nanofil présentant une structure coeur-coquille. Ainsi, l'étape de formation des nano-objets 103 allongés piézoélectriques peut comporter une étape de croissance des âmes 110 comme l'on ferait croître des nanofils simples par exemple par nucléation depuis la première électrode 101, puis une étape de dépôt conforme du matériau de passivation électrique destiné à former les couches 111 de passivation électrique sur les âmes 110 obtenues par croissance. Ensuite, les première et deuxième couches 104, 105 peuvent être successivement formées en déposant :
- la première couche 104 entre les nano-objets 103 allongés piézoélectriques et sur du matériau de passivation électrique déposé sur la première électrode 101 lors de la formation des couches 111 de passivation électrique, ce matériau de passivation à la base de chacun des nano-objets 103 allongés piézoélectriques contribue à la tenue mécanique de ladite base, puis
- la deuxième couche 105 sur la première couche 104.

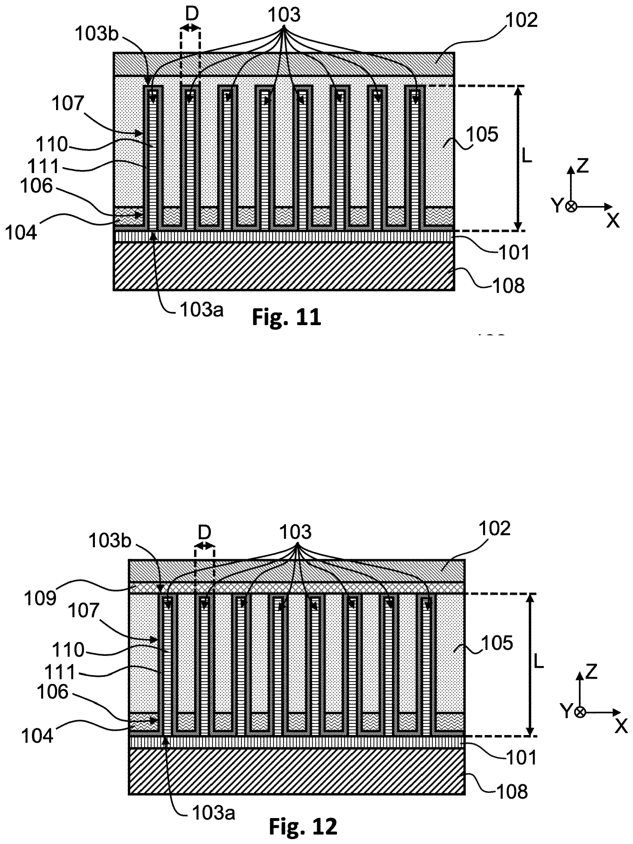

La formation de la deuxième électrode 102 peut être telle que décrite précédemment. En figure 10, le dispositif 100 piézoélectrique est selon le premier mode de réalisation pour lequel les deuxièmes extrémités 103b longitudinales sont formées par du matériau de passivation électrique en contact avec la deuxième électrode 102. En figure 11, le dispositif 100 piézoélectrique est selon le deuxième mode de réalisation pour lequel les deuxièmes extrémités 103b longitudinales sont formées par du matériau de passivation électrique et sont à distance de la deuxième électrode 102 car enrobées par la deuxième couche 105. En figure 12, le dispositif 100 piézoélectrique est selon le troisième mode de réalisation pour lequel les deuxièmes extrémités 103b longitudinales sont formées par du matériau de passivation électrique en contact avec la troisième couche 109.

En cas de présence des couches 111 de passivation électrique, la première couche 104 est séparée de la première électrode 101 par du matériau de passivation électrique d'épaisseur correspondant à l'épaisseur des couches 111 de passivation.

La première couche 104 peut être en contact avec la première électrode 101, dans ce cas les nano-objets 103 allongés piézoélectriques peuvent être de simples nanofils ou des nanotubes.

De manière générale, que la première couche 104 soit en contact avec la première électrode 101 ou séparée de la première électrode 101 par le matériau de passivation électrique, elle est considérée comme étant au niveau, ou du côté, des premières extrémités 103a longitudinales.

Lorsque les nano-objets 103 allongés piézoélectriques sont des nanotubes, il s'agit par exemple de nanotubes d'oxyde de zinc ou de nanotubes de nitrure de gallium. Les nanotubes peuvent présenter chacun un diamètre externe compris entre 100 nm et quelques centaines de nanomètres, et une épaisseur de paroi comprise entre quelques nanomètres et quelques dizaines de nanomètres, cette paroi permettant de définir le diamètre externe et un diamètre interne du nanotube correspondant. Par exemple, les nano-objets 103 allongés piézoélectriques peuvent être formés chacun par un nanotube de nitrure de gallium présentant un diamètre interne compris entre 30 nm et 200 nm, et un diamètre externe compris entre 35 nm et 250 nm par exemple défini à l'aide d'une paroi de nanotube d'épaisseur comprise entre 5 nm et 50 nm.

Le dispositif 100 piézoélectrique tel que décrit présente une application industrielle dans le domaine de la récupération d'énergie par effet piézoélectrique. L'énergie récupérée, sous la forme d'un signal électrique, peut être utilisée dans le contexte d'un nanogénérateur piézoélectrique (dans ce cas le dispositif 100 piézoélectrique est optimisé pour récupérer de l'énergie) ou encore dans le contexte d'un capteur de pression (dans ce cas le dispositif 100 piézoélectrique est optimisé pour avoir une sensibilité adaptée pour déterminer ensuite la pression mesurée).

De manière générale, lorsque les nano-objets 103 allongés piézoélectriques sont en nitrure de gallium ou en oxyde de zinc, le nitrure de gallium ou l'oxyde de zinc peut être dopé. Typiquement, le nitrure de gallium est généralement moins dopé naturellement que ne l'est l'oxyde de zinc, l'oxyde de zinc étant généralement dopé N. Un dopage intentionnel des nano-objets 103 allongés piézoélectriques peut être réalisé pour compenser le dopage naturel, ce dopage naturel pouvant diminuer l'effet piézoélectrique nano-objets 103 allongés piézoélectriques, en vue d'améliorer cet effet piézoélectrique.

Le dispositif 100 piézoélectrique tel que décrit peut aussi trouver une application industrielle dans le domaine du retour haptique. Ainsi, le dispositif 100 piézoélectrique peut être un dispositif haptique permettant de reproduire des sensations de toucher par exemple pour interface tactile. Dans ce cas, la première électrode 101 et la deuxième électrode 102 permettent d'appliquer un champ électrique pour déformer les nano-objets 103 allongés piézoélectriques afin d'assurer le retour haptique souhaité.

Autrement dit, le dispositif 100 piézoélectrique peut former un capteur de pression, un nanogénérateur piézoélectrique ou un dispositif haptique.

## Revendications

1. Dispositif (100) piézoélectrique comportant :
- une première électrode (101),
- une deuxième électrode (102),
- des nano-objets (103) allongés piézoélectriques en contact avec la première électrode (101), les nano-objets (103) allongés piézoélectriques s'étendant entre la première électrode (101) et la deuxième électrode (102),
- une première couche (104) d'un premier matériau, le premier matériau étant électriquement isolant, la première couche (104) entourant une première portion (106) longitudinale de chacun des nano-objets (103) allongés piézoélectriques, **caractérisé en ce que** :
- le dispositif (100) piézoélectrique comporte une deuxième couche (105) d'un deuxième matériau, le deuxième matériau étant électriquement isolant, la deuxième couche (105) entourant une deuxième portion (107) longitudinale de chacun des nano-objets (103) allongés piézoélectriques,
- la première couche (104) est agencée entre la première électrode (101) et la deuxième couche (105),
- l'épaisseur de la première couche (104) est strictement inférieure à l'épaisseur de la deuxième couche (105),
- le premier matériau présente un module de Young strictement supérieur au module de Young du deuxième matériau.

2. Dispositif (100) piézoélectrique selon la revendication 1, **caractérisé en ce que** le module de Young du premier matériau est supérieur ou égal à 5 GPa.

3. Dispositif (100) piézoélectrique selon l'une quelconque des revendications 1 à 2, **caractérisé en ce que** le premier matériau est choisi parmi : un silsesquioxane d'hydrogène, le dioxyde de silicium, l'alumine et un nitrure de silicium.

4. Dispositif (100) piézoélectrique selon l'une quelconque des revendications 1 à 3, **caractérisé en ce que** le module de Young du deuxième matériau est strictement inférieur à 5 GPa.

5. Dispositif (100) piézoélectrique selon l'une quelconque des revendications 1 à 4, **caractérisé en ce que** le deuxième matériau est choisi parmi : le polyméthacrylate de méthyle, un silsesquioxane d'hydrogène, une résine SU-8, un polydiméthylsiloxane, un parylène C, et une résine à base d'un polymère organique et contenant du silicium.

6. Dispositif (100) piézoélectrique selon l'une quelconque des revendications précédentes, **caractérisé en ce que** chaque nano-objet (103) allongé piézoélectrique présente un rapport de forme égal à L/D, avec L étant la longueur dudit nano-objet (103) allongé piézoélectrique et D étant la dimension transversale maximale dudit nano-objet (103) allongé piézoélectrique, le rapport de forme étant supérieur ou égal à 5 et D étant inférieure ou égale à 500 nm.

7. Dispositif (100) piézoélectrique selon l'une quelconque des revendications 1 à 6, **caractérisé en ce que** :
- la longueur (L) de chacun des nano-objets (103) allongés est strictement supérieure à la somme de l'épaisseur (e₁) de la première couche (104) et de l'épaisseur (e₂) de la deuxième couche (105),
- la deuxième électrode (102) est en contact avec les nano-objets (103) allongés piézoélectriques,
- au moins l'une des première et deuxième électrodes (101,102) forme un contact Schottky avec les nano-objets (103) allongés piézoélectriques.

8. Dispositif (100) piézoélectrique selon l'une quelconque des revendications 1 à 6, **caractérisé en ce que** la longueur (L) de chacun des nano-objets (103) allongés piézoélectriques est strictement inférieure à la somme de l'épaisseur (e₁) de la première couche (104) et de l'épaisseur (e₂) de la deuxième couche (105) et **en ce que** la deuxième électrode (102) est à distance des nano-objets (103) allongés piézoélectriques.

9. Dispositif (100) piézoélectrique selon l'une quelconque des revendications 1 à 6, **caractérisé en ce que** les nano-objets (103) allongés piézoélectriques comportent chacun une première extrémité (103a) longitudinale et une deuxième extrémité (103b) longitudinale, les premières extrémités (103a) longitudinales étant en contact avec la première électrode (101) et les deuxièmes extrémités (103b) longitudinales étant en contact avec une troisième couche (109) d'un matériau électriquement isolant, la troisième couche (109) reliant les deuxièmes extrémités (103b) longitudinales à la deuxième électrode (102).

10. Dispositif (100) piézoélectrique selon la revendication 9, **caractérisé en ce que** le matériau électriquement isolant de la troisième couche (109) présente une permittivité relative supérieure ou égale à 3,9.

11. Dispositif (100) piézoélectrique selon la revendication 10, **caractérisé en ce que** le matériau électriquement isolant de la troisième couche (109) est choisi parmi : un oxyde d'aluminium, un nitrure de silicium et un oxyde d'hafnium.

12. Dispositif (100) piézoélectrique selon l'une quelconque des revendications 1 à 11, **caractérisé en ce que** les nano-objets (103) allongés piézoélectriques sont :
- des nanofils d'oxyde de zinc ou de nitrure de gallium, ou
- des nanotubes d'oxyde de zinc ou de nitrure de gallium, ou
- des nanofils comportant chacun une âme (110) en oxyde de zinc ou en nitrure de gallium, et une couche (111) de passivation électrique agencée sur ladite âme (110).

13. Dispositif (100) piézoélectrique selon l'une quelconque des revendications 1 à 12, **caractérisé en ce que** l'épaisseur de la première couche (104) est inférieure ou égale à 20 % de la longueur des nano-objets (103) allongés piézoélectriques.

14. Dispositif (100) piézoélectrique selon l'une quelconque des revendications 1 à 13, **caractérisé en ce qu'**il forme un capteur de pression, un nanogénérateur piézoélectrique ou un dispositif haptique.

15. Procédé de fabrication d'un dispositif (100) piézoélectrique, le procédé de fabrication comportant :
- une étape de formation de nano-objets (103) allongés piézoélectriques sur une première électrode (101),
- une étape de formation d'une première couche (104) d'un premier matériau de sorte que la première couche (104) formée entoure une première portion (106) longitudinale de chacun des nano-objets (103) allongés piézoélectriques, le premier matériau étant électriquement isolant,
- une étape de formation d'une deuxième électrode (102), la deuxième électrode (102) formée étant agencée de sorte que les nano-objets (103) allongés piézoélectriques s'étendent entre la première électrode (101) et la deuxième électrode (102),
**caractérisé en ce que** :
- il comporte une étape de formation d'une deuxième couche (105) d'un deuxième matériau de sorte que la deuxième couche (105) formée entoure une deuxième portion (107) longitudinale de chacun des nano-objets (103) allongés piézoélectriques, le deuxième matériau étant électriquement isolant,
- la première couche (104) est agencée entre la première électrode (101) et la deuxième couche (105),
- l'épaisseur de la première couche (104) formée est strictement inférieure à l'épaisseur de la deuxième couche (105) formée,
- le premier matériau présente un module de Young strictement supérieur au module de Young du deuxième matériau.

## Patentansprüche

1. Piezoelektrische Vorrichtung (100), umfassend:
- eine erste Elektrode (101),
- eine zweite Elektrode (102),
- längliche piezoelektrische Nanoobjekte (103), die sich mit der ersten Elektrode (101) in Kontakt befinden, wobei sich die länglichen piezoelektrischen Nanoobjekte (103) zwischen der ersten Elektrode (101) und der zweiten Elektrode (102) erstrecken,
- eine erste Schicht (104) aus einem ersten Material, wobei das erste Material elektrisch isolierend ist, wobei die erste Schicht (104) einen ersten Längsabschnitt (106) jedes der länglichen piezoelektrischen Nanoobjekte (103) umgibt,
**dadurch gekennzeichnet, dass**:
- die piezoelektrische Vorrichtung (100) eine zweite Schicht (105) aus einem zweiten Material umfasst, wobei das zweite Material elektrisch isolierend ist, wobei die zweite Schicht (105) einen zweiten Längsabschnitt (107) jedes der länglichen piezoelektrischen Nanoobjekte (103) umgibt,
- die erste Schicht (104) zwischen der ersten Elektrode (101) und der zweiten Schicht (105) angeordnet ist,
- die Dicke der ersten Schicht (104) streng kleiner ist als die Dicke der zweiten Schicht (105),
- das erste Material einen Elastizitätsmodul aufweist, der streng größer ist als der Elastizitätsmodul des zweiten Materials.

2. Piezoelektrische Vorrichtung (100) nach Anspruch 1, **dadurch gekennzeichnet, dass** der Elastizitätsmodul des ersten Materials größer oder gleich 5 GPA ist.

3. Piezoelektrische Vorrichtung (100) nach einem der Ansprüche 1 bis 2, **dadurch gekennzeichnet, dass** das erste Material ausgewählt ist aus: einem Wasserstoff-Silsesquioxan, Siliciumdioxid, Aluminiumoxid und einem Siliciumnitrid.

4. Piezoelektrische Vorrichtung (100) nach einem der Ansprüche 1 bis 3, **dadurch gekennzeichnet, dass** der Elastizitätsmodul des zweiten Materials streng kleiner als 5 GPa ist.

5. Piezoelektrische Vorrichtung (100) nach einem der Ansprüche 1 bis 4, **dadurch gekennzeichnet, dass** das zweite Material ausgewählt ist aus: Polymethylmethacrylat, einem Wasserstoff-Silsesquioxan, einem SU-8-Harz, einem Polydimethylsiloxan, einem Parylen C und einem Harz auf Basis eines organischen Polymers, das Silicium enthält.

6. Piezoelektrische Vorrichtung (100) nach einem der vorstehenden Ansprüche, **dadurch gekennzeichnet, dass** jedes längliche piezoelektrische Nanoobjekt (103) ein Seitenverhältnis von gleich L/D aufweist, wobei L die Länge des länglichen piezoelektrischen Nanoobjekts (103) ist, und D die maximale Querabmessung des länglichen piezoelektrischen Nanoobjekts (103) ist, wobei das Seitenverhältnis größer oder gleich 5 ist, und D kleiner oder gleich 500 nm ist.

7. Piezoelektrische Vorrichtung (100) nach einem der Ansprüche 1 bis 6, **dadurch gekennzeichnet, dass**:
- die Länge (L) jedes der länglichen Nanoobjekte (103) streng größer ist als die Summe aus der Dicke (e₁) der ersten Schicht (104) und der Dicke (e₂) der zweiten Schicht (105),
- sich die zweite Elektrode (102) mit den länglichen piezoelektrischen Nanoobjekten (103) in Kontakt befindet,
- mindestens eine aus der ersten und der zweiten Elektrode (101, 102) mit den länglichen piezoelektrischen Nanoobjekten (103) einen Schottky-Kontakt bildet.

8. Piezoelektrische Vorrichtung (100) nach einem der Ansprüche 1 bis 6, **dadurch gekennzeichnet, dass** die Länge (L) jedes der länglichen piezoelektrischen Nanoobjekte (103) streng kleiner ist als die Summe aus der Dicke (e₁) der ersten Schicht (104) und der Dicke (e₂) der zweiten Schicht (105), und dadurch, dass sich die zweite Elektrode (102) in Abstand von den länglichen piezoelektrischen Nanoobjekten (103) befindet.

9. Piezoelektrische Vorrichtung (100) nach einem der Ansprüche 1 bis 6, **dadurch gekennzeichnet, dass** die länglichen piezoelektrischen Nanoobjekte (103) jeweils ein erstes Längsende (103a) und ein zweites Längsende (103b) umfassen, wobei sich die ersten Längsenden (103a) mit der ersten Elektrode (101) in Kontakt befinden, und sich die zweiten Längsenden (103b) mit einer dritten Schicht (109) aus einem elektrisch isolierenden Material in Kontakt befinden, wobei die dritte Schicht (109) die zweiten Längsenden (103b) mit der zweiten Elektrode (102) verbindet.

10. Piezoelektrische Vorrichtung (100) nach Anspruch 9, **dadurch gekennzeichnet, dass** das elektrisch isolierende Material der dritten Schicht (109) eine relative Dielektrizitätskonstante von größer oder gleich 3,9 aufweist.

11. Piezoelektrische Vorrichtung (100) nach Anspruch 10, **dadurch gekennzeichnet, dass** das elektrisch isolierende Material der dritten Schicht (109) ausgewählt ist aus: einem Aluminiumoxid, einem Siliciumnitrid und einem Hafniumoxid.

12. Piezoelektrische Vorrichtung (100) nach einem der Ansprüche 1 bis 11, **dadurch gekennzeichnet, dass** es sich bei den länglichen piezoelektrischen Nanoobjekten (103) handelt um:
- Nanodrähte aus Zinkoxid oder Galliumnitrid, oder
- Nanoröhren aus Zinkoxid oder Galliumnitrid, oder
- Nanodrähte, die jeweils einen Kern (110) aus Zinkoxid oder aus Galliumnitrid, und eine auf dem Kern (110) angeordnete elektrische Passivierungsschicht (111) umfassen.

13. Piezoelektrische Vorrichtung (100) nach einem der Ansprüche 1 bis 12, **dadurch gekennzeichnet, dass** die Dicke der ersten Schicht (104) kleiner oder gleich 20 % der Länge der länglichen piezoelektrischen Nanoobjekte (103) ist.

14. Piezoelektrische Vorrichtung (100) nach einem der Ansprüche 1 bis 13, **dadurch gekennzeichnet, dass** sie einen Drucksensor, einen piezoelektrischen Nanogenerator oder eine haptische Vorrichtung bildet.

15. Verfahren zur Herstellung einer piezoelektrischen Vorrichtung (100), wobei das Herstellungsverfahren umfasst:
- einen Schritt des Bildens von länglichen piezoelektrischen Nanoobjekten (103) auf einer ersten Elektrode (101),
- einen Schritt des Bildens einer ersten Schicht (104) aus einem ersten Material so, dass die gebildete erste Schicht (104) einen ersten Längsabschnitt (106) jedes der länglichen piezoelektrischen Nanoobjekte (103) umgibt, wobei das erste Material elektrisch isolierend ist,
- einen Schritt des Bildens einer zweiten Elektrode (102), wobei die gebildete zweite Elektrode (102) so angeordnet ist, dass sich die länglichen piezoelektrischen Nanoobjekte (103) zwischen der ersten Elektrode (101) und der zweiten Elektrode (102) erstrecken,
**dadurch gekennzeichnet, dass**:
- es einen Schritt des Bildens einer zweiten Schicht (105) aus einem zweiten Material so umfasst, dass die gebildete zweite Schicht (105) einen zweiten Längsabschnitt (107) jedes der länglichen piezoelektrischen Nanoobjekte (103) umgibt, wobei das zweite Material elektrisch isolierend ist,
- die erste Schicht (104) zwischen der ersten Elektrode (101) und der zweiten Schicht (105) angeordnet ist,
- die Dicke der gebildeten ersten Schicht (104) streng kleiner ist als die Dicke der gebildeten zweiten Schicht (105),
- das erste Material einen Elastizitätsmodul aufweist, der streng größer ist als der Elastizitätsmodul des zweiten Materials.

## Claims

1. A piezoelectric device (100) including:
- a first electrode (101),
- a second electrode (102),
- elongated piezoelectric nano-objects (103) in contact with the first electrode (101), the elongated piezoelectric nano-objects (103) extending between the first electrode (101) and the second electrode (102),
- a first layer (104) of a first material, the first material being electrically insulating, the first layer (104) surrounding a first longitudinal portion (106) of each of the elongated piezoelectric nano-objects (103),
**characterized in that**:
- the piezoelectric device (100) includes a second layer (105) of a second material, the second material being electrically insulating, the second layer (105) surrounding a second longitudinal portion (107) of each of the elongated piezoelectric nano-objects (103),
- the first layer (104) is arranged between the first electrode (101) and the second layer (105),
- the thickness of the first layer (104) is strictly less than the thickness of the second layer (105),
- the first material has a Young's modulus strictly greater than the Young's modulus of the second material.

2. The piezoelectric device (100) according to claim 1, **characterized in that** the Young's modulus of the first material is greater than or equal to 5 GPa.

3. The piezoelectric device (100) according to any one of claims 1 to 2, **characterized in that** the first material is selected from: a hydrogen silsesquioxane, silicon dioxide, alumina and a silicon nitride.

4. The piezoelectric device (100) according to any one of claims 1 to 3, **characterized in that** the Young's modulus of the second material is strictly less than 5 GPa.

5. The piezoelectric device (100) according to any one of claims 1 to 4, **characterized in that** the second material is selected from: polymethyl methacrylate, a hydrogen silsesquioxane, an SU-8 resin, a polydimethylsiloxane, a parylene C, and an organic polymer and containing silicon-based resin.

6. The piezoelectric device (100) according to any one of the preceding claims, **characterized in that** each elongated piezoelectric nano-object (103) has an aspect ratio equal to L/D, with L being the length of said elongated piezoelectric nano-object (103) and D being the maximum transverse dimension of said elongated piezoelectric nano-object (103), the aspect ratio being greater than or equal to 5 and D being less than or equal to 500 nm.

7. The piezoelectric device (100) according to any one of claims 1 to 6, **characterized in that**:
- the length (L) of each of the elongated nano-objects (103) is strictly greater than the sum of the thickness (e₁) of the first layer (104) and the thickness (e₂) of the second layer (105),
- the second electrode (102) is in contact with the elongated piezoelectric nano-objects (103),
- at least one of the first and second electrodes (101,102) forms a Schottky contact with the elongated piezoelectric nano-objects (103).

8. The piezoelectric device (100) according to any one of claims 1 to 6, **characterized in that** the length (L) of each of the elongated piezoelectric nano-objects (103) is strictly less than the sum of the thickness (e₁) of the first layer (104) and the thickness (e₂) of the second layer (105) and **in that** the second electrode (102) is at a distance from the elongated piezoelectric nano-objects (103).

9. The piezoelectric device (100) according to any one of claims 1 to 6, **characterized in that** the elongated piezoelectric nano-objects (103) each include a first longitudinal end (103a) and a second longitudinal end (103b), the first longitudinal ends (103a) being in contact with the first electrode (101) and the second longitudinal ends (103b) being in contact with a third layer (109) of an electrically insulating material, the third layer (109) connecting the longitudinal second ends (103b) to the second electrode (102).

10. The piezoelectric device (100) according to claim 9, **characterized in that** the electrically insulating material of the third layer (109) has a relative permittivity greater than or equal to 3.9.

11. The piezoelectric device (100) according to claim 10, **characterized in that** the electrically insulating material of the third layer (109) is selected from: an aluminum oxide, a silicon nitride and a hafnium oxide.

12. The piezoelectric device (100) according to any one of claims 1 to 11, **characterized in that** the elongated piezoelectric nano-objects (103) are:
- zinc oxide or gallium nitride nanowires, or
- zinc oxide or gallium nitride nanotubes, or
- nanowires each including a core (110) made of zinc oxide or gallium nitride, and an electrical passivation layer (111) arranged on said core (110).

13. The piezoelectric device (100) according to any one of claims 1 to 12, **characterized in that** the thickness of the first layer (104) is less than or equal to 20% of the length of the elongated piezoelectric nano-objects (103).

14. The piezoelectric device (100) according to any one of claims 1 to 13, **characterized in that** it forms a pressure sensor, a piezoelectric nanogenerator or a haptic device.

15. A method for manufacturing a piezoelectric device (100), the manufacturing method including:
- a step of forming elongated piezoelectric nano-objects (103) on a first electrode (101),
- a step of forming a first layer (104) of a first material so that the first formed layer (104) surrounds a first longitudinal portion (106) of each of the elongated piezoelectric nano-objects (103), the first material being electrically insulating,
- a step of forming a second electrode (102), the second formed electrode (102) being arranged so that the elongated piezoelectric nano-objects (103) extend between the first electrode (101) and the second electrode (102),
**characterized in that**:
- it includes a step of forming a second layer (105) of a second material so that the second formed layer (105) surrounds a second longitudinal portion (107) of each of the elongated piezoelectric nano-objects (103), the second material being electrically insulating,
- the first layer (104) is arranged between the first electrode (101) and the second layer (105),
- the thickness of the first formed layer (104) is strictly less than the thickness of the second formed layer (105),
- the first material has a Young's modulus strictly greater than the Young's modulus of the second material.
